(19) Europäisches Patentamt
European Patent Office
Office européen des brevets

(11) **EP 1 460 147 A1**

(12) **EUROPEAN PATENT APPLICATION**

(43) Date of publication:
**22.09.2004 Bulletin 2004/39**

(51) Int Cl.7: **C23C 16/50**, C23C 16/26,
H01J 37/32, H05H 1/44,
C23C 16/27, C23C 16/513

(21) Application number: **04011069.4**

(22) Date of filing: **09.09.1999**

| | |
|---|---|
| (84) Designated Contracting States:<br>**DE FR GB**<br><br>(30) Priority: **09.09.1998 US 150456**<br><br>(62) Document number(s) of the earlier application(s) in accordance with Art. 76 EPC:<br>**99117804.7 / 0 985 742**<br><br>(71) Applicant: **Saint-Gobain Industrial Ceramics, Inc. Worcester, MA 01615-0138 (US)** | (72) Inventor: **Simpson, Matthew A.**<br>**Sudbury MA 01776 (US)**<br><br>(74) Representative:<br>**DIEHL GLAESER HILTL & PARTNER**<br>**Patentanwälte**<br>**Augustenstrasse 46**<br>**80333 München (DE)**<br><br>Remarks:<br>This application was filed on 10.05.2004 as a divisional application to the application mentioned under INID code 62. |

(54) **Plasma jet chemical vapor deposition system having a plurality of distribution heads**

(57)     An arc jet CVD system (10) includes a plurality of plasma jet distribution heads (18). The distribution heads (18) are preferably linearly arranged, preferably angled relative to a line normal to the substrate surface on which a diamond film is being coated, and preferably spaced relatively apart with respect to a defined profile width. In addition, the plasma jets are preferably configured in accord with a defined parameter which is a function of the reagent gas flow and viscosity, the distance between the distribution heads (18) and the substrate (32), and the area on the substrate exposed to the gas from a distribution head (18). Configuring the plasma in accordance with the defined parameter-ensures an acceptable minimum level of efficiency with respect to hydrogen reagent use, and further provides a relatively uniform diamond film coating on a substrate.

FIG. 1

**Description**

This invention relates broadly to a chemical vapor deposition system (hereinafter "CVD").

The utility for high quality diamond films for various applications is well known. Superior physical, chemical, and electrical properties make diamond films desirable for many mechanical, thermal, optical and electronic applications. For example, diamond has the highest room-temperature thermal conductivity of any material, a high electric field breakdown ($\sim 10^7$ V/cm), and an air stable negative electron affinity. These properties make possible high power, high frequency transistors and cold cathodes, which cannot be made with any semiconductor other than diamond.

One method for producing thin diamond films is by using a CDV system. In CVD systems, a mixture of hydrogen and a gaseous hydrocarbon, such as methane, is activated and contacted with a substrate to produce a diamond film on the substrate. The hydrogen gas is disassociated into atomic hydrogen, which is then reacted with the hydrocarbon to form condensable carbon radicals. The carbon radicals are then deposited on a substrate to form a diamond film.

One manner of practicing CVD is with a plasma jet system. In plasma jet systems, atomic hydrogen gas is typically introduced into a plasma torch which produces a hydrogen plasma jet by means of a direct current arc (hereinafter "DC arc"), or an alternating current arc ("AC arc"), or microwave energy. The plasma torch is hot enough (typically approximately 10,000 K) to reduce gases to their elemental form. The torch is directed to the substrate for coating, and the reagents exit a nozzle, or distribution head, and are directed at the substrate.

One disadvantage of conventional plasma jet systems is that the distribution of the diamond coating is substantially fixed; i.e., the diamond coating is deposited with a roughly Gaussian distribution with substantially greater coating thickness directly beneath the distribution head and substantially lesser coating thicknesses located about the periphery of the distribution head. Therefore, the coating thickness is not uniform, and the thinner coating regions are often unusable for the required purpose and relegated to waste. As a result, the cost of the unusable diamond film must be allocated to the usable diamond film, adding cost to the usable diamond film. In addition, the coating process is relatively time consuming, especially with larger substrates, further adding to the cost.

Recently, a plasma jet device utilizing three distribution heads arranged to relatively quickly deposit a diamond film has been described. U.S. Patent No. 5,667,852 to Kulik et al. discloses a plasma jet system having three axially symmetrically arranged convergent jets, i.e., the jets are all directed at a single location, such that the effective distance between the separate jets is zero. The convergent configuration permits a relatively rapid coating of the diamond film on a substrate located beneath the jets. However, it is believed that the convergent configuration is highly inefficient and will produce significant waste of the hydrogen reagent, which is relatively expensive. This is because the hydrogen reagent at the periphery of the convergent stream of reagent will be diffused away from the central reagent gas stream line and provide for a very slow, inefficient coating process at the periphery in which a substantial portion of the hydrogen reagent will be lost. Furthermore, the convergent configuration of the jets, which are subject to laminar flow dynamics, will additionally cause reagent to flow away from the substrate and contribute to reagent loss. Moreover, the convergent configuration will not satisfy concerns regarding non-uniformity of coating thickness over the entirety of a substrate having a width greater than the locus of convergence of the three jets. This concern is especially important as typically diamond films yield only a thirty percent usable portion, and the three convergent jets, in effect, would provide substantially the same Gaussian non-uniformity as a single jet, only relatively quicker. The diamond film at the periphery will be substantially thinner than more central portions, and will need to be discarded.

U.S. Patent No. 5,403,399 to Kurihara et al. also discloses a plasma jet system having a plurality of jets having an effective distance between the jets which is greater than zero. The plurality of jets are used to increase the diamond film deposition rate and also to produce relatively thicker films than possible with a single jet. However, the jets described in Kurihara are not spaced such that thickness uniformity of the deposited film will result. Moreover, the several configurations of the jets are highly inefficient and will produce significant waste of the hydrogen reagent.

As an alternative to a plasma jet system, it is known to use a glow discharge CVD system which heats a cathode to a relatively low temperature, typically at temperatures up to 2000°C, to provide the thermal activation temperatures necessary to bring about the plasmatic conversion described above, and directs the carbon radicals toward the substrate. U.S. Patent No. 5,647,964 to Lee et al. describes a glow discharge device using three cathodes which are provided in triangular arrangement, each parallelly directed and equidistant from the substrate. The operation of this class of system gives rise to problems which are non-analogous to those experienced with plasma jet systems, primarily because there is no distribution head utilized. In the glow discharge method, uniformity of coating is easier to achieve. However, the cathode is subject to contamination. That is, solid carbon forms on the cathode, gradually builds up, and eventually reaches and covers the end of the cathode such that plasma cannot be obtained. In addition, as the carbon build-up is typically uneven on the circumferential surface of the cathode, the current flow is biased so that the cathode becomes only partially heated and is subject to arcing between the cathode and the substrate, discontinuing deposition of the diamond film. Therefore, it is often not desirable to use a glow discharge system.

It is therefore the object of the present invention to provide a plasma jet CVD system which overcomes the drawbacks of the prior art products. This object is solved by the plasma jet CVD system according to independent claim 1. Further advantageous features, aspects and details of the invention are evident from the dependent claims, the description and the drawings. The claims are to be understood as a first non-limiting approach to define the invention in general terms.

More particularly, this invention relates to a plasma jet chemical vapor deposition system using a plurality of deposition heads.

In one aspect of the invention a plasma jet CVD system having a plurality of non-convergent distribution heads is provided.

It is a further aspect of the invention to provide a plasma jet system which includes a plurality of distribution heads which generates a substantially uniform thickness diamond film over the surface of the substrate on which the diamond film is provided. It is an additional aspect of the invention to provide a plasma jet system which efficiently uses hydrogen reagent.

It is also an aspect of the invention to provide a plasma jet system which has optimal relative distances between a plurality of the distribution heads.

In accord with these aspects, which will be discussed in detail below, a plasma jet CVD system is provided which includes a plurality of plasma jet distribution heads. The distribution heads may be angled with respect to the substrate. This allows an additional degree of freedom for the control deposition of particular value for jets on the edge of an array, but increases the standoff measured along the jet centerline between the jet and the substrate, which makes efficient hydrogen capture more difficult. It also reduces the heat flux density to the substrate, which assists temperature control. The distribution heads are preferably spaced apart from each other with respect to the profile width of the plasma exiting the distribution heads, such as to provide a relatively uniform coating on the substrate. In addition, the plurality of jets and the substrate may be moved relative to one another during diamond film deposition for increased uniformity. The distribution heads are also preferably configured in accord with a defined parameter, which is a function of several other parameters pertaining to the distribution heads including the reagent gas flow and viscosity, the distance between a distribution head and the substrate, and the area on the substrate exposed to the gas from a particular distribution head. Configuring the distribution heads in accordance with the defined parameter ensures an acceptable minimum level of efficiency with respect to hydrogen reagent use. The combination of arranging the distribution heads with respect to the profile width and in accord with the defined parameter, and the relative movement of the distribution heads and the substrate provide an efficient process for manufacturing substantially uniform thickness diamond film.

Additional aspects and advantages of the invention will become apparent to those skilled in the art upon reference to the detailed description taken in conjunction with the provided figures, in which

Figure 1 is a front view of a multiple distribution head plasma jet CVD system according to the invention;

Figure 2 is a section view of one of the jet systems of the CVD system of the invention, the jet system shown rotated 90° relative to the view in Figure 1;

Figure 3 is a top view of an array of plasma jet distribution heads according to the invention;

Figure 4 is a side view of an array of plasma jet distribution heads according to the invention;

Figure 5 is a graph of the deposition profile of a plasma jet distribution head;

Figure 6 is a graph of measurements relating to capture efficiency and a parameter $\Phi$ and a best fit curve therethrough.

Figure 7 is a schematic top view of a two dimensional array of plasma jet distribution heads according to a first alternate embodiment of the invention; and

Figure 8 is a schematic top view of a two dimensional array of plasma jet distribution heads according to a second alternate embodiment of the invention.

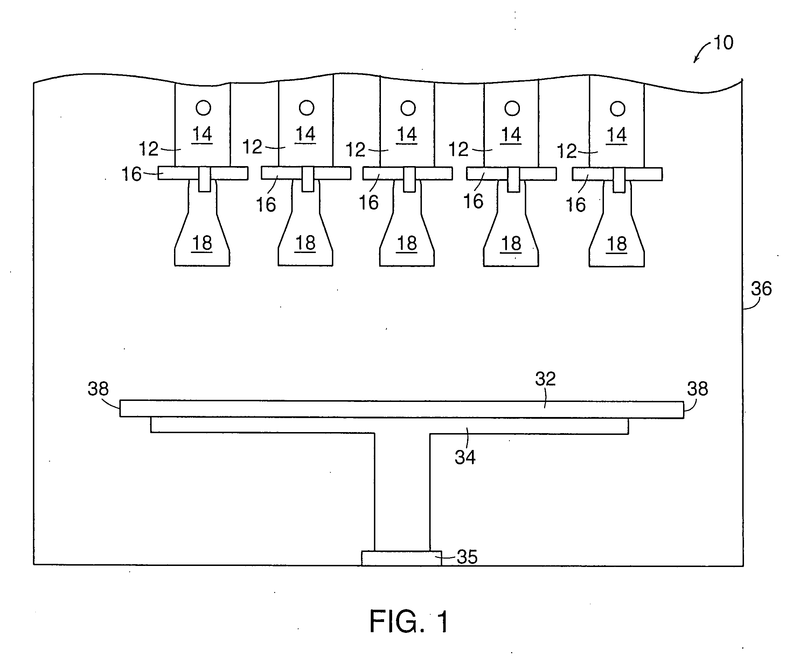

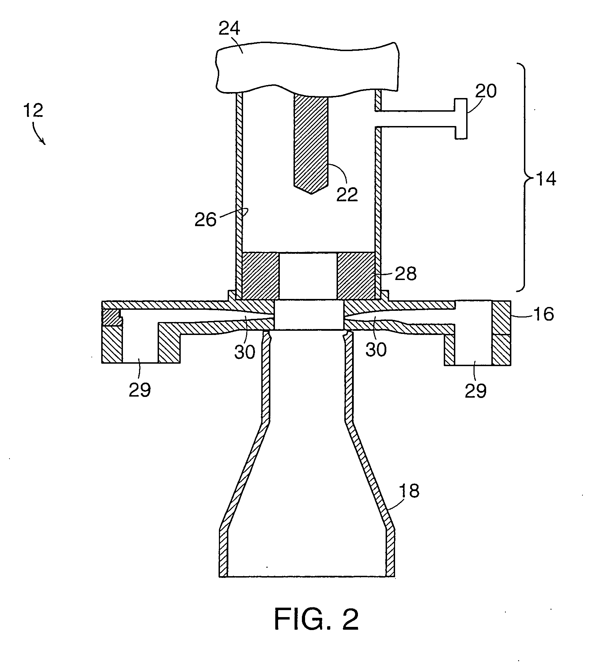

Turning now to Figures 1 and 2, a plasma jet CVD system 10 generally includes a plurality of, e.g., five, jet systems 12, each having an engine 14, a gas injection disc 16, and a plasma jet distribution head (nozzle) 18. Each engine 14 is preferably an arc jet engine and includes a lateral hydrogen gas inlet 20, a cathode 22, an engine wall 24, an insulative lining 26 on the engine wall, and an anode 28. The gas injection disc 16 is provided with gas feeds 29 and gas injection ports 30. The plurality of distribution heads 18 are directed towards a substrate 32 which is preferably movable on a support 34 relative to the distribution heads via moving means 35, e.g., a motorized mechanism. The moving means 35 may be adapted to rotationally or linearly move the support relative to the distribution heads 18, depending upon the geometry of the substrate 32. The substrate 32 may be a mandrel for the deposition of free standing diamond film, or may be a surface on which the diamond film is intended to be relatively permanently applied. A vacuum deposition chamber 36 surrounds the jet systems 12, the support 34, and the substrate 32 located thereon.

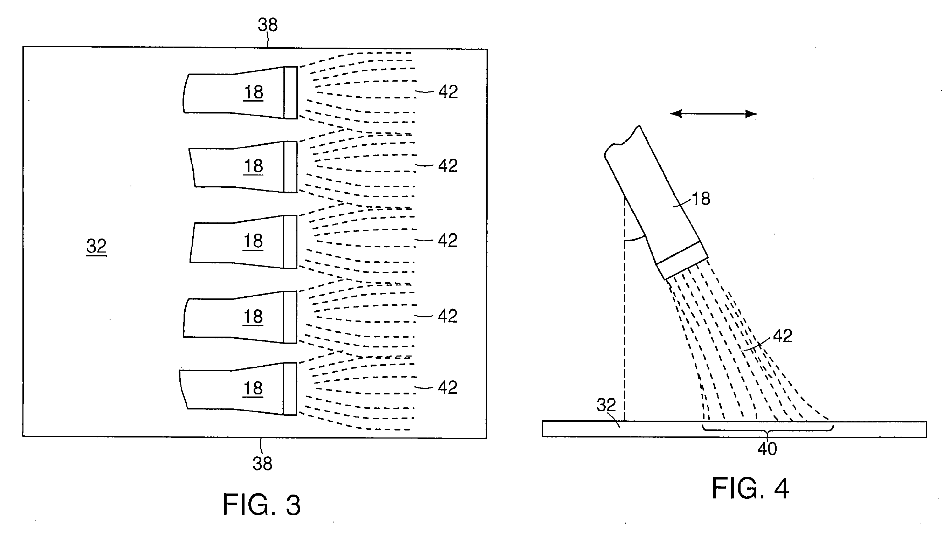

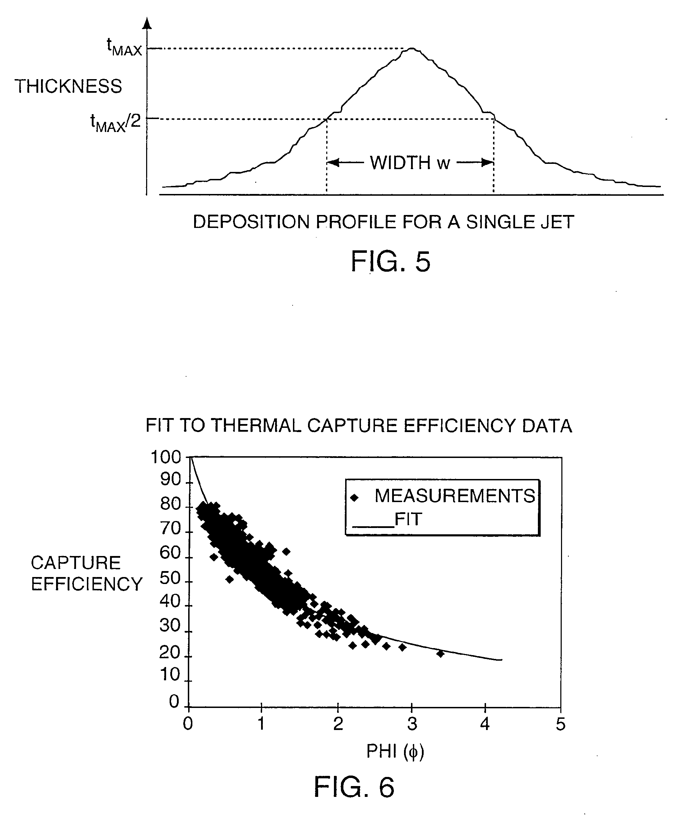

Referring to Figures 3 and 4, the distribution heads 18 are preferably linearly arranged. Preferably, the linear arrangement extends generally across the width of the substrate upon which diamond film is being coated and, more preferably, to conserve reagents, extends at most to within one half inch of the edges 38 of the substrate material. If the array extends closer to the edges 38, reagent may be sprayed beyond the edge of the substrate and be wasted. The distribution heads 18 are preferably optimally spaced apart from each other. That is, if the distribution heads are provided too far apart, there will exist issues with respect to diamond film coating thickness uniformity. According to a preferred aspect of the invention, it has been found that each point on the substrate where uniform thickness is desired must pass within a half a "profile width" of the impingement point of at least one jet. More particularly, referring to Figure 5, the "profile width" is taken to be the width w between the points on the deposition profile at which deposition occurs at half the maximum rate; that is $t_{max}/2$. In situations where different jet assemblies within an array of jets have different profiles (e.g., as often happens at the edge of an array), "profile widths" appropriate to such jet assemblies should be used.

It is noted that when the substrate is not moved relative to the jets, the distribution heads should preferably be spaced apart (from center to center) within one half of a "profile width" of each other in order that each point on the substrate is within half a "profile width" of an impingement point of at least one distribution head. A relatively uniform diamond film coating thickness is thereby provided.

Furthermore, those regions on the substrate which are influenced by one jet only must be positioned especially close to the impingement point of the jet. For example, if the thickness uniformity is required to be within ± 5% of the desired thickness, acceptable regions of the substrate must pass close enough to the impingement point of the head so that the profile height is within 5% of the maximum value. This typically equates to within approximately one quarter of a "profile width". Such considerations are particularly relevant for the outermost distribution heads in an array because they are most likely to be coating substrate regions that are affected by only one jet. That part of the substrate which is more than one quarter of a "profile width" away from the impingement points of the outermost distribution heads represents wasted reagents (and wasted substrate, as the substrate will not have the required coating thickness). In order to maximize capture efficiency, reagent waste must be minimized. This can be partly accomplished by inclining the outermost distribution heads toward the center of the array (at angles preferably between approximately 10 to 60 degrees, and more preferably at approximately 25 degrees). Such inclining skews the deposition profile so that more material is deposited in the direction of incline than if the distribution heads were at normal incidence.

This novel arrangement prevents the distribution heads from being positioned too far apart relative to each other, and permits a relatively large area to be more quickly and uniformly coated. However, if the distribution heads are spaced too closely together, the plasma (which is subject to laminar flow) exiting one distribution head will interfere with the plasma exiting adjacent distribution heads. Such interference will cause the atomic hydrogen to be forced up and away from the substrate and thereby remain unused (and wasted) in the coating process. Therefore, the energy capture efficiency, i.e., the efficient use of reagents, and particularly the efficient use of the relatively expensive hydrogen reagent, should preferably also be considered.

According to another preferred aspect of the invention, it has been determined that energy capture efficiency can be maintained at an acceptable level by controlling several plasma jet parameters with respect to each other. More particularly, a parameter $\Phi$ has been defined which when calculated to be less than 1 indicates that the energy capture efficiency will be greater than fifty percent; hence, atomic hydrogen use is likewise expected to be greater than fifty percent, which is considered by the inventor to be an acceptable minimum level of efficiency. The parameter $\Phi$ is preferably calculated as follows:

$$\Phi(N_s, N_p, N_r, \mathrm{Re}) = a_1 N_s + a_2 N_s{}^2 + b_1 N_p + b_2 N_p{}^2$$
$$+ c_1 N_r + c_2 N_r{}^2 + d_1 \mathrm{Re} + d_2 \mathrm{Re}^2$$
$$+ e_1 N_s N_r + e_2 N_s \mathrm{Re} + f_1 N_p \mathrm{Re} + f_2 N_r \mathrm{Re}$$

where the constants $a_i$, $b_i$, $c_i$, $d_i$, $e_i$, $f_i$ ($i = 1,2$) have the following preferred values experimentally obtained by fitting a curve, shown as Figure 6, to measurements relating to capture efficiency and $\Phi$ :

| Constant | Subscript | |
| --- | --- | --- |
| | i=1 | i=2 |
| A | -0.48 | -0.067 |
| B | 0 | 0 |
| C | 7.1 | -6.5 |
| D | -0.0050 | 0.000018 |
| E | 1.57 | 0.0057 |
| F | 0.017 | -0.042 |

and the symbols $N_s$, $N_p$, $N_r$, and Re are dimensionless combinations of physical constants and experimental geometry. The symbols are defined as follows.

$N_s$ equals $d_{st}/d_{su}$, where $d_{st}$ is the standoff (distance) between the deposition head 18 and the substrate 32 measured along the jet axis (except for systems having jets with high Mach numbers, where the standoff should be measured between the substrate and the location where the supersonic core of the jet fades away), and $d_{su}$ is the equivalent diameter of the substrate exposed to the jet; i.e., $d_{su} = 2(A_s/1)^{1/2}$, where $A_s$ is the area on the substrate exposed to gas from a particular jet. In the determination of $A_s$, it will be appreciated that gas exits the jet, flows along the substrate and usually meets another gas flow from another jet, and then is diverted up and away from the substrate. In some cases there may be a further recirculation of the gas bringing the gas back down to the substrate again, but most of the active species are gone from this gas flow. Therefore, the area $A_s$ exposed to the gas jet is only the area exposed on the first pass. It will be appreciated that in same cases, e.g., where a linear array of jets is inclined (as described below with respect to Figures 3 and 4), the area $A_s$ may be highly elongated; however, because of depletion of the reagents, area more distant from the impingement point of the jet than about three times the width of the contact area where the jet impinges should be ignored.

$N_p$ equals $p_t/p_b$, where $p_t$ is the density of the gas in the jet once it expands to the pressure in the deposition chamber 36, and $p_b$ is the density of the background gas in the deposition chamber 36.

$N_r$ equals $d_j/d_{su}$, where $d_j$ is an estimated jet diameter and is defined by $d_j = M/(V_j p_t)^{1/2}$, with M being the mass flow through the jet, $V_j$ being the estimated sound speed for a jet defined by $V_j = (1.5 P/p_t)^{1/2}$, where P is the pressure in the jet, and $p_t$ being the density of the gas in the jet once it expands to the pressure in the deposition chamber 36, and where $d_{su}$ is the equivalent diameter of the substrate exposed to the jet; i.e., $d_{su} = 2 (A_s/1)^{1/2}$, where $A_s$ is the area on the substrate exposed to gas from a particular jet.

Re is the Reynolds number and equals $d_j v_j p_t/v$, where $d_j$ is an estimated jet diameter and is defined by $d_j = M/(v_j p_t)^{1/2}$, where M is the mass flow through the jet, where $v_j$ is the estimated sound speed for a jet and is defined by $v_j = (1.5 P/p_t)^{1/2}$, where P is the pressure in the jet, and where $p_t$ is the density of the gas in the jet once it expands to the pressure in the deposition chamber, and where v is the viscosity of the gas in the jet once the gas expands to the pressure in the deposition chamber.

Data for the graph shown in Figure 6 were obtained by correlating the heat transferred from a plasma torch to various substrates with the operating parameters of the torch and the geometrical arrangement. Since atomic hydrogen transport and heat transport are strongly correlated, the fraction of atomic hydrogen captured by the substrate was taken to be a fraction of the heat captured.

Configuring the plasma jet assemblies in accordance with parameter $\Phi$, i.e., such that $\Phi$ has the reasonably lowest value with respect to each plasma jet, and preferably a value less than one, ensures a desirable minimum level of efficiency with respect to hydrogen reagent use.

In addition, referring back to Figures 3 and 4 and according to yet another preferred aspect of the invention, the distribution heads 18 are preferably provided angled, or angleable, relative to a line normal to the substrate 32. The angle is preferably between approximately 20° and 60°. The angle of the distribution heads relative to the substrate decreases heat flux and increases the substrate surface contact area 40 of the reagents 42 exiting each distribution head 18 (Figs. 3 and 4). In addition, the relatively large contact surface area 40 created by an angled head limits the number of distribution heads required for a particular application. Moreover, the angleability of the distribution heads provides an additional degree of freedom which may be additionally advantageous in certain circumstances.

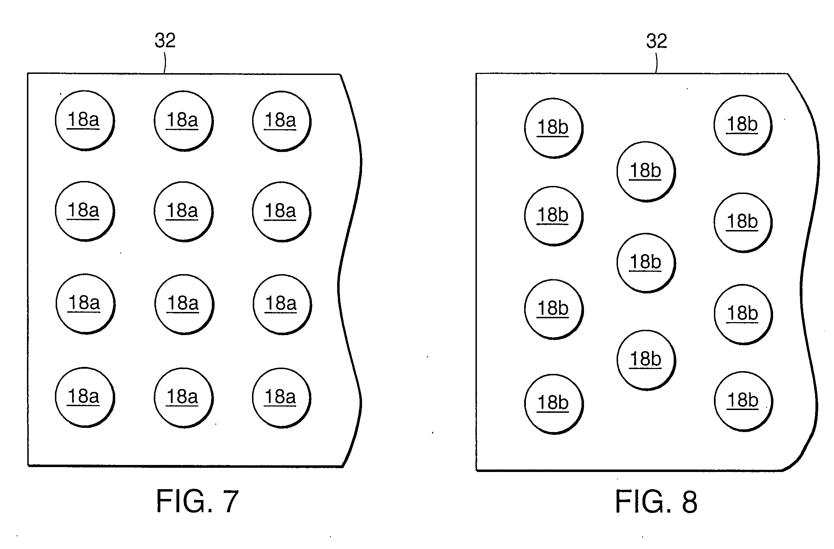

Turning now to Figures 7 and 8, it will be appreciated that a two dimensional array of jet systems may also be provided. With respect to Figure 7, a first alternate embodiment is shown in which the distribution heads 18a are arranged in rows in two dimensions over the substrate 32, each row being preferably aligned with the adjacent row. With respect to Figure 8, a second alternate embodiment is shown in which the jet systems 18b in adjacent rows are offset relative to one another. The number (and rows) of jet systems is limited only by the capacity of the chamber and the ability to couple each jet system to gas and reagent inlets.

Referring back to Figures 1 and 2, with respect to each jet system 12, hydrogen gas enters the hydrogen gas inlet 20 and is heated (at approximately 10,000 K) to a partial plasma state (plasma flux) by an arc across the cathode 22 and the anode 28. Hydrogen is injected into the plasma and imparts a vortex swirl to the plasma. Downstream, hydrocarbon injectant and carrier hydrogen gas enters the gas injection disc 16 from gas supply feeds 29 and exits the gas injection ports 30 into the vortex swirl of plasma. The injectant and carrier gas mix and react with the hydrogen plasma, resulting in a mixture of molecular hydrogen, atomic hydrogen and carbon radicals. The mixture exits through the distribution head 18 and is directed at the substrate 32. When the mixture strikes the relatively cool substrate 32, a polycrystalline diamond film is deposited on the substrate.

The uniformity of coating thickness is further facilitated by moving the distribution heads and the substrate relative to one another during diamond film deposition. The support 34 and the distribution heads 18 are preferably movable relative to each other such that the substrate 32 may be relatively moved in a direction substantially perpendicular to the linear array of distribution heads 18 as shown by the arrow in Figure 4. For linear-shaped substrates, it is preferable that the substrate material be moved once under the distribution heads at a relatively slow rate, e.g., 0.1 meter/hour, which effectuates complete coverage during the single pass. For an annular or other substantially circular shaped substrate, it is preferable that the substrate be moved under the distribution heads at a relatively faster rate, e.g., up to 4 meter/second or faster, which requires a substantial number of passes thereunder to effectuate the desired diamond film coating thickness.

The combination of arranging the distribution heads with respect to a profile width and desired angle, configuring the plasma jets in accord with parameter Φ, and moving the distribution heads relative to the substrate provide an efficient process for manufacturing substantially uniform thickness diamond film.

There have been described and illustrated herein a multiple distribution head plasma jet CVD system. While particular embodiments of the invention have been described, it is not intended that the invention be limited thereto, as it is intended that the invention be as broad in scope as the art will allow and that the specification be read likewise. Thus, while an arc jet system has been disclosed, it will be appreciated that other types of plasma jet systems, e.g., microwave energy, can be used as well. Furthermore, while each distribution head is described as having a separate engine associated therewith, it will be appreciated that more than one distribution head may be fed from an engine. Also, with respect to parameter Φ, different values could be used for the constants. Furthermore, parameter Φ may be otherwise calculated such that an energy capture efficiency of fifty percent is not provided by Φ equal to one. Moreover, a different parameter using some or all different variables may be used. It will therefore be appreciated by those skilled in the art that modifications could be made to the provided invention without deviating from its spirit and scope as so claimed.

**Claims**

1. A multiple plasma jet CVD system (10) for depositing a diamond film on a substrate material (32), comprising:

   a) a plurality of distribution heads (18) which are substantially parallelly directed, each of said distribution heads (18) having a means for producing a plasma; and

   b) a deposition chamber (36) surrounding said distribution heads (18),

   wherein a first of said plurality of distribution heads (18) is separated from a second of said plurality of distribution heads (18) such that plasma directed from said first distribution head (18) has a first central impingement point on the substrate material, and plasma directed from said second distribution head (18) has a second central impingement point, said second central impingement point being within a half a profile width of said first central impingement point.

2. A multiple plasma jet CVD system (10) according to claim 1, wherein:

   said plurality of distribution heads (18) are provided in a substantially linear arrangement.

3. A multiple plasma jet CVD system (10) according to claim 1, wherein:

   said plurality of distribution heads (18) are substantially parallelly directed.

4. A multiple plasma jet CVD system (10) according to claims 2 or 3, wherein:

   said linear arrangement extends to within approximately one-half inch of an edge of the substrate material (32).

5. A multiple plasma jet CVD system (10) according to claims 1 to 4, wherein:

   at least one of said plurality of distribution heads (18) has parameters configured such that an energy capture efficiency of said at least one of said plurality of distribution heads exceeds fifty percent.

6. A multiple plasma jet CVD system according to claims 1 to 5, wherein:

   said plurality of distribution heads (18) are directed at the substrate material (32) at an angle between approximately 20° and 60° relative to a line normal to the substrate material (32).

7. A multiple plasma jet CVD system (10) according to claims 1 to 6, wherein:

   said distribution heads (18) are arranged in a two dimensional array.

8. A multiple plasma jet CVD system (10) according to claim 7, wherein:

   said distribution heads (18) are arranged in a plurality of rows which are aligned relative to one another.

9. A multiple plasma jet CVD system (10) according to claim 7, wherein:

   said distribution heads (18) are arranged in a plurality of rows which are offset relative to one another.

**10.** A multiple plasma jet CVD system (10) according to claims 1 to 9, further comprising:

c) means for moving (35) said substrate material relative to said distribution heads.

FIG. 1

FIG. 2

EP 1 460 147 A1

**FIG. 3**

**FIG. 4**

$t_{MAX}$

THICKNESS

$t_{MAX}/2$

← WIDTH w →

DEPOSITION PROFILE FOR A SINGLE JET

## FIG. 5

FIT TO THERMAL CAPTURE EFFICIENCY DATA

CAPTURE
EFFICIENCY

◆ MEASUREMENTS
― FIT

PHI ($\phi$)

## FIG. 6

EP 1 460 147 A1

32

18a   18a   18a

18a   18a   18a

18a   18a   18a

18a   18a   18a

FIG. 7

32

18b         18b

    18b

18b         18b

    18b

18b         18b

    18b

18b         18b

FIG. 8

## EUROPEAN SEARCH REPORT

European Patent
Office

Application Number

EP 04 01 1069

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 560 779 A (KULL ALAN E ET AL) 1 October 1996 (1996-10-01) * column 1, lines 7-12 * * column 5, lines 3-41; figures 5-7 * ----- | 1 | C23C16/50 C23C16/26 H01J37/32 H05H1/44 C23C16/27 C23C16/513 |
| A | US 5 481 081 A (FUJIMORI NAOJI ET AL) 2 January 1996 (1996-01-02) * column 20, line 53 - column 24, line 11; figures 6,7A,7B * ----- | 1 | |
| A | US 3 660 630 A (SUNNEN JEAN A F ET AL) 2 May 1972 (1972-05-02) * column 2, line 34 - column 3, line 2; figures 7,8 * ----- | 1 | |
| A | EP 0 839 928 A (ZEISS STIFTUNG ;SCHOTT GLASWERKE (DE)) 6 May 1998 (1998-05-06) * the whole document * ----- | 1 | |

| | | | TECHNICAL FIELDS SEARCHED (Int.Cl.7) |
|---|---|---|---|
| | | | C23C H05H |

The present search report has been drawn up for all claims

| Place of search | Date of completion of the search | Examiner |
|---|---|---|
| Munich | 16 July 2004 | Joffreau, P-0 |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 01 1069

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2004

| Patent document cited in search report | | | Publication date | Patent family member(s) | | Publication date |
|---|---|---|---|---|---|---|
| US 5560779 | A | | 01-10-1996 | NONE | | |
| US 5481081 | A | | 02-01-1996 | JP | 3203754 B2 | 27-08-2001 |
| | | | | JP | 5279182 A | 26-10-1993 |
| | | | | DE | 69303404 D1 | 08-08-1996 |
| | | | | DE | 69303404 T2 | 14-11-1996 |
| | | | | EP | 0564156 A1 | 06-10-1993 |
| | | | | US | 5539176 A | 23-07-1996 |
| | | | | ZA | 9302211 A | 13-10-1993 |
| US 3660630 | A | | 02-05-1972 | DE | 2014592 A1 | 08-10-1970 |
| | | | | FR | 2039566 A5 | 15-01-1971 |
| | | | | JP | 50011107 B | 26-04-1975 |
| EP 0839928 | A | | 06-05-1998 | DE | 19643865 A1 | 07-05-1998 |
| | | | | DE | 59709142 D1 | 20-02-2003 |
| | | | | EP | 0839928 A1 | 06-05-1998 |
| | | | | JP | 10140358 A | 26-05-1998 |
| | | | | US | 6293222 B1 | 25-09-2001 |
| | | | | US | 5985378 A | 16-11-1999 |

EPO FORM P0459

For more details about this annex : see Official Journal of the European Patent Office, No. 12/82